# EUROPEAN PATENT SPECIFICATION

(11) **EP 3 102 016 B1**
(45) Date of publication and mention of the grant of the patent: **07.10.2020**
(21) Application number: 14892529.0
(22) Date of filing: 19.05.2014
(51) Int. Cl.: H05K 13/04

(54) **COMPONENT MOUNTING APPARATUS AND METHOD FOR ARRANGING COMPONENT MOUNTING APPARATUS**
KOMPONENTENMONTAGEVORRICHTUNG UND VERFAHREN ZUR ANORDNUNG EINER KOMPONENTENMONTAGEVORRICHTUNG
APPAREIL DE MONTAGE DE COMPOSANT ET PROCÉDÉ DE MISE EN PLACE D'APPAREIL DE MONTAGE DE COMPOSANT

(43) Date of publication of application: 07.12.2016
(73) Proprietor: Yamaha Hatsudoki Kabushiki Kaisha, Iwata-shi, Shizuoka 438-8501 (JP)
(72) Inventor: ITO, Kota, Iwata-shi Shizuoka 438-8501 (JP); TAMAKI, Eiichi, Iwata-shi Shizuoka 438-8501 (JP)
(74) Representative: Müller-Boré & Partner Patentanwälte PartG mbB
(86) International application number: PCT/JP2014/063187
(87) International publication number: WO 2015/177834

(56) References cited:
- WO-A1-2014/025120
- JP-A- 2005 347 352
- JP-A- 2007 242 757
- JP-A- 2009 302 329
- JP-A- 2010 045 295

## Description

### [TECHNICAL FIELD]

This invention relates to a component mounting apparatus for mounting a component fed by a component feeding apparatus on a board by a head unit and a setup method of the component mounting apparatus.

### [BACKGROUND ART]

Patent literature 1 discloses an electronic component mounting apparatus for mounting components fed by each of a plurality of tape feeders on a board by a transfer head. In this electronic component mounting apparatus, feed reels on which tapes accommodating components are wound are attached to a carriage and the tapes pulled out from the feed reels are attached to the tape feeders. Then, the tape feeders feed the components accommodated in the attached tapes.

Further, at the time of out of component, a new feed reel having a new tape wound thereon is attached to the carriage. Then, an operator performs a splicing operation of joining the new tape pulled out from the feed reel to the tape held in the tape feeder. In this way, the new tape is attached to the tape feeder and the feed of components by the tape feeder is enabled.

### [CITATION LIST]

### [PATENT LITERATURE]

[PATENT LITERATURE 1] JP2003-332796A
[PATENT LITERATURE 2] JP2000-068690A

JP 2009 302329 A discloses a tape feeder which includes a component feed motor for sending a tape containing a component at predetermined intervals. In a state wherein the tape feeder is operable, a time needed for the component feed motor to rotate by a predetermined angle to send one component is detected as a numeral associated with the state of rotation of the component feed motor.

WO 2014/025120 A1 discloses a carrier tape feeding device, a chip mounting system, and a chip mounting method.

### [SUMMARY OF INVENTION]

### [TECHNICAL PROBLEM]

To mount proper components on a board, the tape feeders and the components accommodated by the tapes attached to the tape feeders need to be associated. Thus, when the new tape is attached, it is necessary to be able to recognize the target tape feeder out of the plurality of tape feeders. Accordingly, the application of a barcode technology described in patent literature 2 is considered. That is, if the operator is obliged to read a barcode attached to the target tape feeder by a barcode reader when the tape is attached to the tape feeder, the target tape feeder can be recognized from a barcode reading result.

However, in a state where a plurality of tape feeders are arranged as in the component mounting apparatus of patent literature 1, it is not necessarily easy for an operator to precisely read a barcode of the target tape feeder having a tape attached therein by a barcode reader. This is because, even if the operator thinks that the barcode reader is facing the barcode of the target tape feeder, the barcode reader may be actually facing the barcode of an adjacent tape feeder and an erroneous barcode may be read.

This invention was developed in view of the above problem and aims to provide a technology enabling a component feeding apparatus as an attaching target to be precisely recognized when a component accommodating member such as a tape accommodating components is attached to the component feeding apparatus such as a tape feeder.

### [SOLUTION TO PROBLEM]

To achieve the above aim, a component mounting apparatus according to an aspect of the invention is defined in claim 1. Another aspect of the invention is defined in claim 2.

A set up method of a component mounting apparatus according to an aspect of the invention is defined in claim 3. Another aspect of the invention is defined in claim 4.

In the aspect (component mounting apparatus, setup method of component mounting apparatus) of the invention thus configured, the behavior part is provided for each of the plurality of component feeding apparatuses and each behavior part behaves according to a load applied by the operator to the tape attached to the corresponding component feeding apparatus. The first aspect of the invention is configured to recognize that the tape has been attached to the component feeding apparatus corresponding to the behavior part having the predetermined behavior detected when the predetermined behavior of the behavior part is detected. In such a configuration, an operation required for the operator for the recognition of the component feeding apparatus having the tape attached therein is to apply a load to this tape. Thus, there is a little possibility that the operator applies a load to an erroneous tape since the tape supposed to have a load applied thereto is the exact tape that the operator attached to the component feeding apparatus. As a result, the component feeding apparatus as an attaching target can be precisely recognized when the tape accommodating the components is attached to the component feeding apparatus.

On this occasion, the component mounting apparatus is configured so that the behavior part is a drive motor to drive the tape attached to the component feeding apparatus. In such a configuration, since the drive motor has both a function of driving the tape and a function as the behavior part, a common member can exhibit each function and the configuration of the component mounting apparatus can be simplified.

On this occasion, the component mounting apparatus is configured so that the attaching recognition part detects a behavior of the motor to increase an output against a load received by the tape from the operator as the predetermined behavior. Especially, the component mounting apparatus is configured so that the attaching recognition part detects a behavior of the motor to increase an output to be equal to or larger than a predetermined threshold value against the load received by the tape from the operator as the predetermined behavior. In such a configuration, the operator needs to apply a load not lower than a certain level to the tape in order to notify the attaching of the tape to the component mounting apparatus. Thus, it can be suppressed that the component mounting apparatus erroneously recognizes the attaching of the tape such as due to a load applied to the tape during a splicing operation and a load applied to the tape by unintended contact after the splicing operation.

Alternatively, the component mounting apparatus is configured so that the attaching recognition part detects a behavior of the motor to rotate according to a load received by the tape from the operator as the predetermined behavior. Especially, the component mounting apparatus is configured so that the attaching recognition part detects a behavior of the motor to rotate by a predetermined threshold value or more against the load received by the tape from the operator as the predetermined behavior. In such a configuration, the operator needs to pull the tape by a certain amount or more in order to notify the attaching of the tape to the component mounting apparatus. Thus, it can be suppressed that the component mounting apparatus erroneously recognizes the attaching of the tape such as due to a load applied to the tape during the splicing operation and a load applied to the tape by unintended contact after the splicing operation.

### [ADVANTAGEOUS EFFECTS OF INVENTION]

According to the invention, a component feeding apparatus as an attaching target can be precisely recognized when a component accommodating member such as a tape accommodating components is attached to the component feeding apparatus such as a tape feeder.

### [BRIEF DESCRIPTION OF DRAWINGS]

FIG. 1 is a plan view schematically showing an example of a component mounting apparatus according to the invention.
FIG. 2 is a perspective view showing the external appearance of the component mounting apparatus of FIG. 1.
FIG. 3 is a perspective view showing an example of the feeder provided in the component mounting apparatus of FIG. 1.
FIG. 4 is a perspective view showing a state where the tape pulled out from the reel is attached to the feeder of FIG. 3.
FIG. 5 is a block diagram showing an example of an electrical configuration of the component mounting apparatus.
FIG. 6 is a flow chart showing a first example of operations performed in the setup work.
FIG. 7 is a flow chart showing a second example of operations performed in the setup work.
FIG. 8 is a flow chart showing a third example of operations performed in the setup work.
FIG. 9 is a flow chart showing a fourth example of operations performed in the setup work.

### [DESCRIPTION OF EMBODIMENTS]

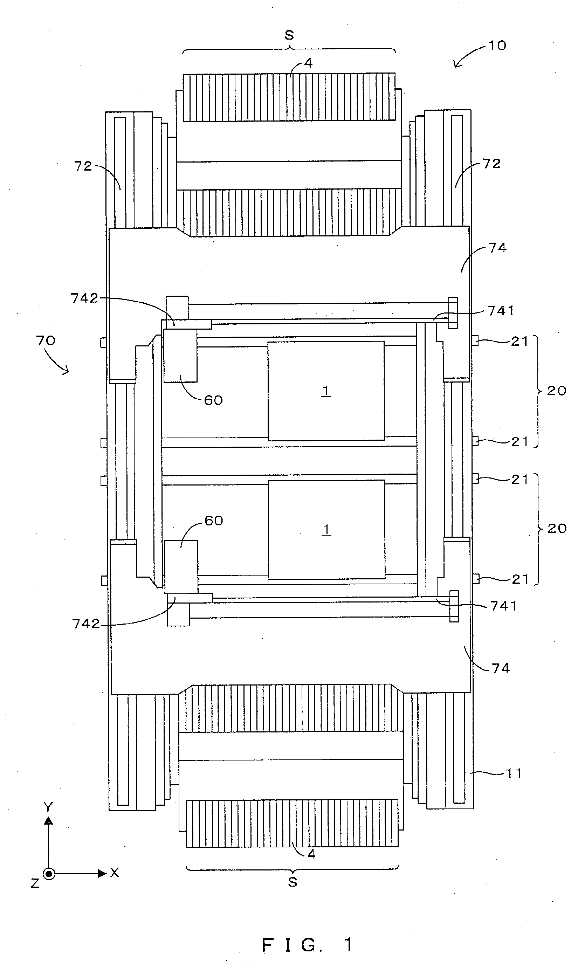

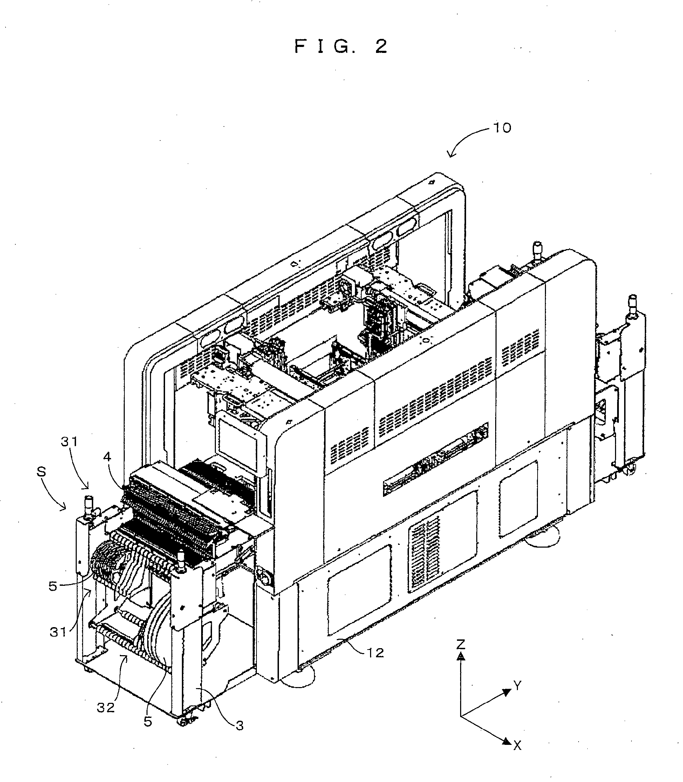

FIG. 1 is a plan view schematically showing an example of a component mounting apparatus according to the invention. FIG. 2 is a perspective view showing the external appearance of the component mounting apparatus of FIG. 1. XYZ orthogonal coordinate axes composed of a board conveying direction X, a width direction Y and a vertical direction Z are shown as appropriate in FIGS. 1, 2 and other figures. A component mounting apparatus 10 is for mounting components fed from component feeding mechanisms S by head units 60 while boards 1 are conveyed by conveying lanes 20.

Specifically, two conveying lanes 20 extend in parallel in the board conveying direction X on a base 11 of the component mounting apparatus 10 and the boards 1 can be conveyed in the board conveying direction X by each conveying lane 20. The conveying lane 20 includes a pair of conveyors 21 for conveying the board 1 in the board conveying direction X on the base 11. The conveying lane 20 conveys the carried-in board 1 to a mounting operation position (position of the board 1 shown in FIG. 1) and stops it at this mounting operation position. Further, an unillustrated holding device is provided for the mounting operation position and the board 1 stopped at the mounting operation position is held by the holding device. Subsequently, the conveying lane 20 carries out the board 1 having components mounted thereon at the mounting operation position in the board conveying direction X from the mounting operation position.

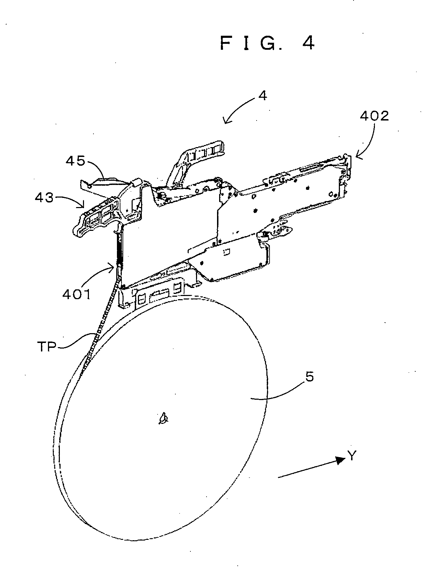

The component feeding mechanism S is arranged at each of opposite sides of these two conveying lanes 20 in the width direction Y. Each component feeding mechanism S is configured such that feeders 4 and reels 5 are attached to a carriage 3 detachably attachable to a housing 12 of the component mounting apparatus 10. The carriage 3 includes a feeder holder 31 for detachably holding a plurality of feeders 4 arranged in a row in the board conveying direction X and a reel holder 32 for detachably holding a plurality of reels 5 arranged in the board conveying direction X at a position obliquely below the feeder holder 31. A tape TP (FIG. 4) accommodating a plurality of components (electronic components) at equal intervals is wound on the reel 5, and the tape TP pulled out from the reel 5 held by the reel holder 32 is attached to the feeder 4 held by the feeder holder 31. Then, the feeder 4 feeds the components accommodated in the attached tape TP toward the conveyor lane 20 and supplies them to a component feeding position.

Further, the component mounting apparatus 10 includes two head units 60 and a moving mechanism 70 for individually moving these head units 60. Each head unit 60 includes a mounting head (not shown) for sucking the component by a nozzle and mounts the component, which is sucked at the component feeding position of the feeder 4, on the board 1 by being moved between the feeder 4 and the board 1 by the moving mechanism 70. The moving mechanism 70 includes two Y-axis rails 72 extending in the width direction Y on the base 11 and two Y-axis sliders 74 installed between these Y-axis rails 72 and configured to move along the Y-axis rails 72. The two Y-axis sliders 74 are provided in correspondence with the two head units 60 and each Y-axis slider 74 moves in the width direction Y together with the head unit 60 while holding the head unit 60. Further, each Y-axis slider 74 includes an X-axis rail 741 extending in the direction X and a block 742 configured to move along the X-axis rail 741, and the head unit 60 is fixed on the block 742. Thus, each head unit 60 is held on the Y-axis slider 74 in a state free to move in the direction X. Therefore, each head unit 60 can be moved in an XY plane by the moving mechanism 70.

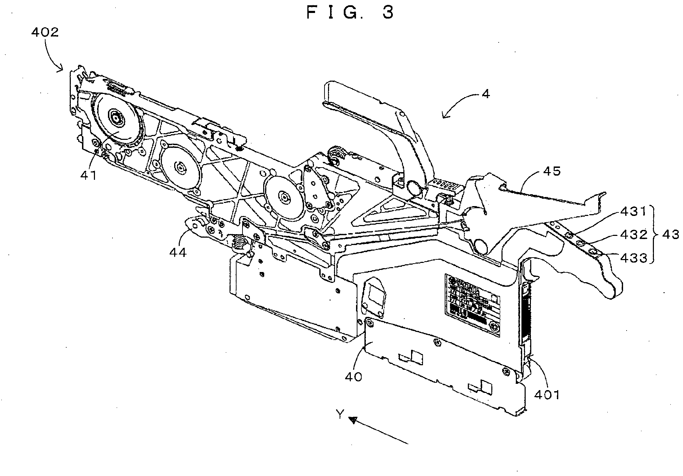

FIG. 3 is a perspective view showing an example of the feeder provided in the component mounting apparatus of FIG. 1. FIG. 4 is a perspective view showing a state where the tape pulled out from the reel is attached to the feeder of FIG. 3. The feeder 4 has a configuration similar to that of a tape feeder described, for example, in JP2013-125880A and is detachably attached to the feeder holder 31 of the carriage 3 from the width direction Y.

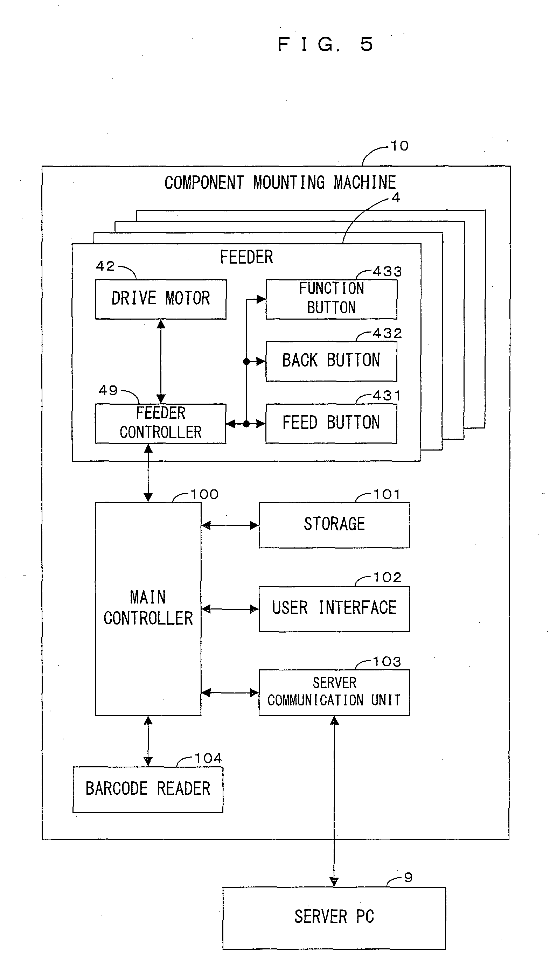

A feeder main body 40 of the feeder 4 includes a tape inlet 401 provided on one end in the width direction Y and a tape outlet 402 provided on the other end in the width direction Y. The tape TP pulled out from the reel 5 is fed into the feeder 4 through the tape inlet 401 and fed out of the feeder 4 through the tape outlet 402. That is, the feeder 4 includes a circular sprocket 41 rotatably supported in the feeder main body 40 at an intermediate position (before the tape outlet 402) of a movement path of the tape TP from the tape inlet 401 to the tape outlet 402. The sprocket 41 is engaged with a plurality of engaging holes of the tape TP provided at equal intervals along a peripheral edge of the tape TP. Further, the feeder main body 40 includes a drive motor 42 (FIG. 5) configured to rotate and drive the sprocket 41 inside and the sprocket 41 rotates by a drive force of the drive motor 42 to move the tape TP.

An operation panel 43 is provided above the tape inlet 401 on the one end of the feeder main body 40 in the width direction Y. Various buttons such as a feed button 431, a back button 432 and a function button 433 operable by an operator are provided on this operation panel 43. For example, if the operator presses the feed button 431, the drive motor 42 rotates in a forward direction to move the tape TP in a feed direction from the tape inlet 401 toward the tape outlet 402. Alternatively, if the operator presses the back button 432, the drive motor 42 rotates in a reverse direction (direction opposite to the forward direction) to move the tape TP in a back direction from the tape outlet 402 toward the tape inlet 401.

The feeder main body 40 is provided with a clamp member 44 projecting toward the tape outlet 402 (toward the other end in the width direction Y). With the feeder 4 attached to the carriage 3, the clamp member 44 is engaged with the carriage 3 and clamped to the carriage 3. Further, on the one end of the feeder main body 40 in the width direction Y, a clamp release lever 45 biased upward is provided. The operator can unclamp the clamp member 44 from the carriage 3 and remove the feeder 4 from the carriage 3 by pressing down the clamp release lever 45.

FIG. 5 is a block diagram showing an example of an electrical configuration of the component mounting apparatus. Note that a server PC (Personal Computer) 9 is shown besides the component mounting apparatus 10 in FIG. 5. As shown in FIG. 5, the component mounting apparatus 10 includes a main controller 100, which is a computer configured by a CPU (Central Processing Unit) and memories, and the main controller 100 integrally controls the operation of the component mounting apparatus 10. Further, the component mounting apparatus 10 includes a storage 101, a user interface 102, a server communication unit 103 and a barcode reader 104. The storage 101 is configured, for example, by an HDD (Hard Disk Drive) and stores various programs such as a production program executed by the main controller 100 and data. The user interface 102 is configured, for example, by a touch panel type liquid crystal display, receives information indicating a state of the component mounting apparatus 10 from the main controller 100 and displays it to the operator, and receives an input from the operator and transmits it to the main controller 100. The server communication unit 103 is an I/O (Input/Output) port for carrying out communication with the server PC 9, receives information indicating a state of the component mounting apparatus 10 from the main controller 100 and transmits it to the server PC 9, and receives a command from the server PC 9 and transmits it to the main controller 100. The barcode reader 104 has a configuration similar to that of a barcode reader described, for example, in JP2000-068690A.

In such a component mounting apparatus 10, the main controller 100 controls each part in accordance with the production program, thereby performing a component mounting operation of transferring the components from the feeders 4 to the board 1. At this time, a distance by which and a timing at which the feeder 4 intermittently moves the tape TP are controlled by the main controller 100. That is, the feeder 4 includes a feeder controller 49, which is a computer configured by CPU (Central Processing Unit) and memories, and the moving distance and timing of the tape TP are controlled by the feeder controller 49 operating the drive motor 42 in accordance with a command from the main controller 100 while the main controller 100 is performing the component mounting operation in accordance with the production program. Specifically, when the component is taken up from the component feeding position by the head unit 60, the feeder controller 49 gives a feed command to the drive motor 42. This causes the drive motor 42 to move the tape TP in the feed direction by a distance corresponding to the feed command and feeds the component to the component feeding position. Further, when the feed of the component to the component feeding position is completed, the feeder controller 49 gives a still command to the drive motor 42. This causes the drive motor 42 to keep the tape TP still.

Further, such as at the time of out of component of the feeder 4 before or during the execution of the component mounting operation, the feeder controller 49 operates the drive motor 42 in accordance with the operation to the operation panel 43 by the operator. For example, the feeder controller 49 gives a feed command to the drive motor 42 to move the tape TP in the feed direction when the feed button 431 is operated, and gives a back command to the drive motor 42 to move the tape TP in the back direction when the back button 432 is operated. While the operation panel 43 is not operated, the feeder controller 49 gives a still command to the drive motor 42 and causes the drive motor 42 to keep the tape TP still.

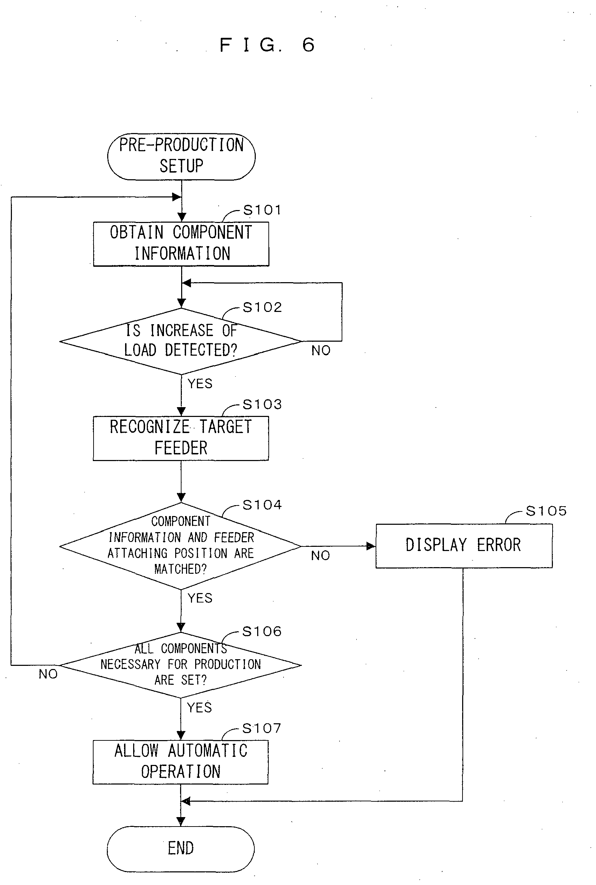

Furthermore, in a setup work during which the operator attaches a new tape TP to the feeder 4 of the component mounting apparatus 10, the main controller 100 and the feeder controller 49 cooperate to function as a "attaching recognition part" and recognizes the feeder 4 as an attaching target of the tape TP out of the plurality of feeders 4. FIG. 6 is a flow chart showing a first example of operations performed in the setup work, particularly showing operations in the setup work (pre-production setup) performed before the board 1 to which the components are mounted by the component mounting operation is produced. Such a flow chart is performed by the cooperation of the main controller 100 and the feeder controller 49 in accordance with a pre-production setup program stored in the storage 101.

In the pre-production setup, the operator reads the barcode attached to the reel 5 wound with the tape TP to be newly attached to the feeder 4 using the barcode reader 104 and attaches this reel 5 in the carriage 3. Note that the barcode of the reel 5 represents component information indicating the type, number and the like of the components accommodated in the tape TP wound on this reel 5. Then, the main controller 100 obtains the component information from the reading result of the barcode reader 104 and stores it in the storage 101.

In subsequent Step S102, it is judged whether or not an increase of a load applied to the tape TP has been detected. That is, in this embodiment, the operator pulls the tape TP as a target of a splicing operation to apply a load to the tape TP when the splicing operation of pulling the tape TP from the reel 5 attached to the carriage 3 and joining it to the tape TP held in the feeder 4 is completed. On the other hand, the drive motor 42 tries to keep the tape TP still since a still command is given thereto from the feeder controller 49. Specifically, the drive motor 42 increases its output torque against the load received by the tape TP from the operator. Then, when detecting a torque increasing behavior of the drive motor 42 to increase the output torque equal to or more than a predetermined threshold value ("YES" in Step S102), the feeder controller 49 recognizes that the tape T has been attached to the feeder 4 corresponding to the drive motor 42 having this torque increasing behavior detected and notifies that recognition result to the main controller 100 (Step S103).

In Step S104, the main controller 100 judges whether or not the attaching position of the feeder 4 supposed to feed the components indicated by the component information and the attaching position of the recognized feeder 4 match by checking the component information obtained in Step S101 and the feeder 4 recognized in Step S103. Note that the attaching position of the feeder 4 supposed to feed the components indicated by the component information is specified based on the production program. If these do not match (NO in Step S104), the main controller 100 displays an error in the user interface 102 (Step S105) and ends the flow chart of FIG. 6. On the other hand, if these match ("YES" in Step S104), the main controller 100 proceeds to Step S106.

In Step S106, the main controller 100 judges whether or not all the components necessary for production are set and arranged in the component mounting apparatus 10. Unless all the components are arranged ("NO" in Step S106), the main controller 100 returns to Step S101. On the other hand, if all the components are arranged ("YES" in Step S106), the main controller 100 proceeds to Step S107 to allow an automatic operation and ends the flow chart of FIG. 6. Here, the automatic operation indicates an operation of feeding the components by giving a feed command to the drive motors 42 in accordance with the production program by the cooperation of the main controller 100 and the feeder controllers 49. By allowing this automatic operation, the feed of the components by the feeders 4 is enabled in the component mounting operation.

As described above, in the embodiment thus configured, the drive motor 42 (behavior part) is provided for each of the plurality of feeders 4 (component feeding apparatuses), and each drive motor 42 behaves according to a load applied by the operator to the tape T attached to the corresponding feeder 4. The component mounting apparatus 10 is configured to, when the torque increasing behavior (predetermined behavior) of the drive motor 42 is detected, recognize that the tape TP has been attached to the feeder 4 corresponding to the drive motor 42 having the torque increasing behavior detected. In such a configuration, an operation required for the operator to let the component mounting apparatus 10 recognize the feeder 4 having the tape TP attached therein is to apply a load to this tape TP. Thus, the tape TP supposed to have a load applied thereto is the exact tape TP that the operator attached to the feeder 4, wherefore there is a little possibility that the operator applies a load to an erroneous tape (i.e. tape TP corresponding to an erroneous feeder 4). As a result, when the tape accommodating the components is attached to the feeder 4, the feeder 4 as an attaching target can be precisely recognized.

Further, the drive motor 42 has both a function of driving the tape TP and a function of behaving according to a load applied to the tape TP. Thus, a common member can exhibit each function and the configuration of the component mounting apparatus 10 can be simplified.

Further, the feeder controller 49 and the main controller 100 recognize the feeder 4 as an attaching target of the tape TP based on a result of detecting a behavior of increasing an output of the drive motor 42 equal to or more than the predetermined threshold value against the load received by the tape TP from the operator. In such a configuration, the operator needs to apply a load not lower than a certain level to the tape TP in order to notify the attaching of the tape TP to the component mounting apparatus 10. Thus, it can be suppressed that the component mounting apparatus 10 erroneously recognizes the attaching of the tape TP such as due to a load applied to the tape TP during the splicing operation and a load applied to the tape TP by unintended contact after the splicing operation.

The setup work described above is also performed when there is a possibility of out of component in the feeder 4 during the production of the board 1 by the component mounting operation. Here, out of component indicates a state where the number of the components accommodated in the tape TP attached to the feeder 4 has become zero. Accordingly, the setup work when there is a possibility of out of component is described next.

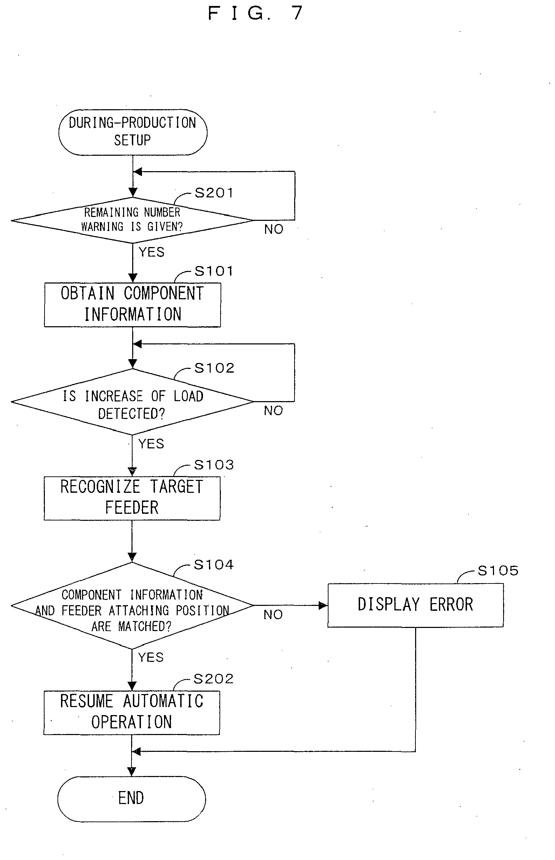

FIG. 7 is a flow chart showing a second example of operations performed in the setup work, particularly showing operations in the setup work (during-production setup) performed during the board 1 to which the components are mounted by the component mounting operation is produced. Such a flow chart is performed by the cooperation of the main controller 100 and the feeder controller 49 in accordance with the pre-production setup program stored in the storage 101. Here, description is centered on points of difference from the operations shown in FIG. 6, and common points are denoted by equivalent reference signs and not described as appropriate. Note that, needless to say, common configurations exhibit similar effects.

The main controller 100 manages the remaining number of the components of each feeder 4 by counting down the number of the mounted components from the number of components indicated by the component information obtained in advance. When the number of the remaining components falls to or below a predetermined number, a possibility of out of component is judged and a remaining number warning is given ("YES" in Step S201). Note that the remaining number warning is also given to the operator by various techniques such as warning light, warning sound and indication on the display. Then, Steps S101 to S105 are performed as described with reference to FIG. 6. As a result, when the attaching of the new tape TP is completed for the feeder 4 for which the remaining number warning was given, an advance is made to Step S202 to resume the automatic operation and ends the flow of the during-production setup of FIG. 7.

Also in such a configuration, the operation required for the operator to let the component mounting apparatus 10 recognize the feeder 4 having the tape TP attached therein is to apply a load to this tape TP. Thus, the tape TP supposed to have a load applied thereto is the exact tape TP that the operator attached to the feeder 4, wherefore there is a little possibility that the operator applies a load to an erroneous tape (i.e. tape TP corresponding to an erroneous feeder 4). As a result, when the tape accommodating the components is attached to the feeder 4, the feeder 4 as an attaching target can be precisely recognized.

Note that the invention is not limited to the above embodiment and various changes other than the aforementioned ones can be made without departing from the gist of the invention. For example, in the above embodiment, an increase of the load applied to the tape TP is detected based on the torque increasing behavior of the drive motor 42 to increase the output torque. However, a specific technique for detecting an increase of the load applied to the tape TP is not limited to this and, for example, a technique described below may be adopted.

That is, in the above embodiment, the feeder controller 49 lets the drive motor 42 keep the tape TP still in the setup work of FIG. 6 or 7. In contrast, in an embodiment described here, the feeder controller 49 gives a constant torque command to keep an output torque constant to the drive motor 42 in the setup work. In such a configuration, if the operator applies a load to the tape TP, the drive motor 42 rotates according to this torque. Accordingly, Steps S102 of FIG. 6 or 7 may be configured such that an increase of the load applied to the tape TP is detected by detecting a rotating behavior (predetermined behavior) of the drive motor 42 to rotate by a predetermined threshold value or more according to the load.

In this embodiment, the component mounting apparatus 10 is configured to, when the rotating behavior of the drive motor 42 is detected, recognize that the tape TP has been attached to the feeder F corresponding to the drive motor 42 having the rotating behavior detected. In such a configuration, the operation required for the operator to let the component mounting apparatus 10 recognize the feeder 4 having the tape TP attached therein is to apply a load to this tape TP. Thus, the tape TP supposed to have a load applied thereto is the exact tape TP that the operator attached to the feeder 4, wherefore there is a little possibility that the operator applies a load to an erroneous tape (i.e. tape TP corresponding to an erroneous feeder 4). As a result, when the tape accommodating the components is attached to the feeder 4, the feeder 4 as a mounting target can be precisely recognized.

Further, the drive motor 42 has both the function of driving the tape TP and the function of behaving according to the load applied to the tape TP. Thus, a common member can exhibit each function and the configuration of the component mounting apparatus 10 can be simplified.

Further, the feeder controller 49 and the main controller 100 recognizes the feeder 4 as an attaching target of the tape TP based on the result of detecting the rotating behavior of the drive motor 42 by the predetermined threshold value or more according to the load received by the tape TP from the operator. In such a configuration, the operator needs to pull the tape TP by a certain amount or more to notify the attaching the tape TP to the component mounting apparatus 10. Thus, it can be suppressed that the component mounting apparatus 10 erroneously recognizes the attaching of the tape TP such as due to a load applied to the tape TP during the splicing operation and a load applied to the tape by unintended contact after the splicing operation.

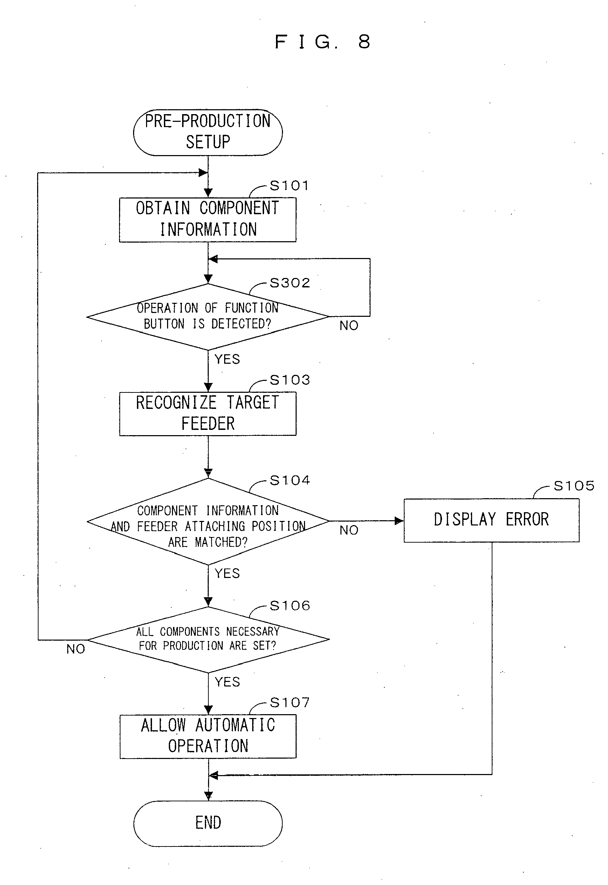

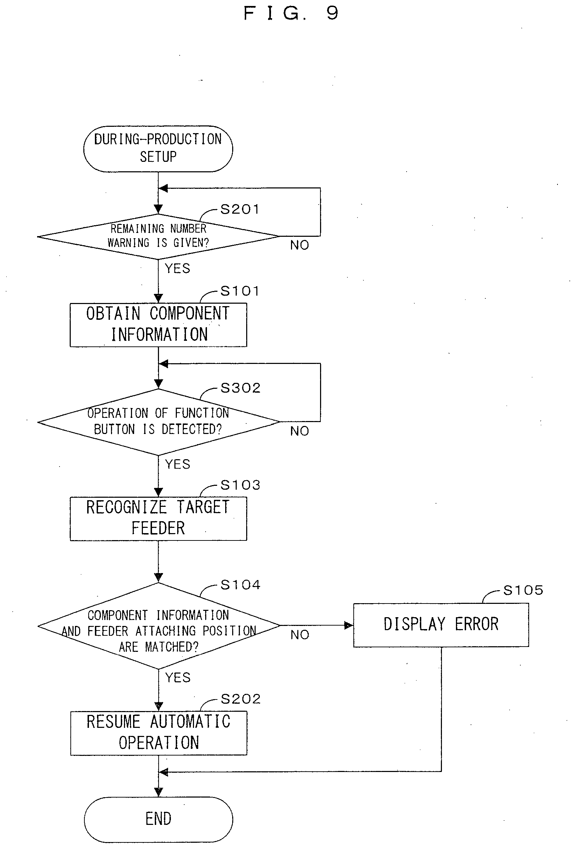

In the above embodiment, the operator applies a load to the tape TP to let the component mounting apparatus 10 recognize the feeder 4 having the tape TP attached therein. However, it is also possible to let the component mounting apparatus 10 recognize the feeder 4 having the tape TP attached therein by a technique other than the application of a load to the tape TP. A specific example is as follows. The operation of any one of the feed button 431, the back button 432 and the function button 433 provided on the operation panel 43, e.g. the function button 433 may let the component mounting apparatus 10 recognize the feeder having the tape TP attached therein. The specific example having such a configuration is described using FIGS. 8 and 9.

FIG. 8 is a flow chart showing a third example of operations performed in the setup work, particularly showing operations in the setup work (pre-production setup) performed before the board 1 to which the components are mounted by the component mounting operation is produced. The flow chart shown in FIG. 8 is basically the same as that shown in FIG. 6 except in that Step S302 of detecting the operation of the function button 433 is performed instead of Step S102. That is, according to the flow chart shown in FIG. 8, when the splicing operation is completed, the operator presses the function button 433 arranged on the feeder 4 as a target. On the other hand, when detecting that the function button 433 has been pressed ("YES" in Step S302), the feeder controller 49 recognizes that the tape TP has been attached to the feeder 4 corresponding to the pressed function button 433 (Step S103).

FIG. 9 is a flow chart showing a fourth example of operations performed in the setup work, particularly showing operations in the setup work (during-production setup) performed during the board 1 to which the components are mounted by the component mounting operation is produced. The flow chart shown in FIG. 9 is basically the same as that shown in FIG. 7 except in that Step S302 of detecting the operation of the function button 433 is performed instead of Step S102. That is, according to the flow chart shown in FIG. 9, when the splicing operation is completed, the operator presses the function button 433 arranged on the feeder 4 as a target. On the other hand, when detecting that the function button 433 has been pressed ("YES" in Step S302), the feeder controller 49 recognizes that the tape TP has been attached to the feeder 4 corresponding to the pressed function button 433 (Step S103).

In the embodiments as described above, the function button 433 (operation part) operable by being pressed (touched) by the operator is provided for each of the plurality of feeders 4. The component mounting apparatus 10 is configured to detect the operation of the function button 433 and recognize that the tape TP (component accommodating member) has been attached to the feeder 4 corresponding to the operated function button 433. In such a configuration, the operation required for the operator for the recognition of the feeder 4 having the tape TP attached therein is to touch and operate the function button 43 provided for the feeder 4 as a target. Thus, the operator can operate the function button 433 while confirming the function button 433 by touching it, wherefore there is a little possibility the operator operates an erroneous function button 433 (i.e. the function button 433 of an erroneous feeder 4). As a result, the feeder 4 as an attaching target can be precisely recognized when the tape TP accommodating the components is attached to the feeder 4.

Incidentally, a press of the function button 433 arranged on the feeder 4 lets the component mounting apparatus 10 recognize the feeder 4 having the tape TP attached therein here. However, buttons may be arranged on the feeder holder 31 (holder) of the carriage 3 in correspondence with the respective feeders 4 and the component mounting apparatus 10 may be configured to recognize the feeder 4 having the tape TP attached therein when this button is pressed.

Further, various modifications are possible besides these modifications. For example, an increase of the load applied to the tape TP is detected based on the behavior of the drive motor 42 in the first and second examples. However, the tape TP may be wound around and supported by a bias roller (behavior part) biased by a spring or the like and Step S102 may be configured to detect an increase of the load applied to the tape TP by the operator by detecting a displacement (predetermined behavior) of the bias roller according to the increase of the load applied to the tape TP by the operator. Alternatively, a button (behavior part) may be held in contact with the tape TP and Step S102 may be configured to detect an increase of the load applied to the tape TP by the operator by detecting a displacement (predetermined behavior) of the button pressed down by the tape TP according to the increase of the load applied to the tape TP by the operator.

Further, in the third and fourth examples, the operation of the function button 433 lets the component mounting apparatus 10 recognize the feeder 4 having the tape TP attached therein. However, the operation of a member other than the buttons such as the clamp release lever 45 may let the component mounting apparatus 10 recognize the feeder 4 having the tape TP attached therein.

Further, in the above examples, the feeder 4 and the reel 5 are separately arranged while being spaced apart from each other. However, the invention can be applied also when the feeder 4 and the reel 5 are integrally configured as in JP2000-068690A.

Further, the type of the feeders 4 is not limited to the above one and, for example, tape feeders described in JP2009-272377A and the like can be used. Particularly, in the above third and fourth examples, it is possible to use feeders other than tape feeders, e.g. stick feeders described in JP2009-302184A. That is, the stick feeder having a stick accommodating components newly attached therein can be recognized by executing the flow of the third or fourth example.

### [REFRENCE SIGN LIST]

- 1...: board
- 10...: component mounting apparatus
- 100...: main controller (attaching recognition part)
- 104...: barcode reader
- S...: component feeding mechanism
- 3...: carriage
- 31...: feeder holder (holder)
- 32...: reel holder
- TP...: tape (component accommodating member)
- 4...: feeder (component feeding apparatus)
- 42...: drive motor (behavior part)
- 433...: function button (operation part)
- 44...: clump member
- 45...: clump release lever
- 49...: feeder controller (attaching recognition part)
- 5...: reel
- 60...: head unit
- 9...: server PC

## Claims

1. A component mounting apparatus (10), comprising:
a reel holder (32) configured to detachably hold reels (5) having tapes (TP) accommodating components wound thereon;
a plurality of component feeding apparatuses (4) configured to feed the components accommodated in the attached tapes (TP), the tapes (TP) pulled out from the reels (5) held by the reel holder (32) being attachable to the component feeding apparatuses (4);
a head unit (60) configured to mount the components fed by the component feeding apparatuses (4) on a board (1); and
a behavior part (42) which is provided for each of the plurality of component feeding apparatuses (4) and configured to behave according to a load applied by an operator to the tape (TP) attached to the corresponding component feeding apparatus (4), wherein the behavior part (42) is a drive motor (42) configured to drive the tape (TP) attached to the component feeding apparatus (4);
**characterized by**
an attaching recognition part (49, 100) configured to give a still command to the drive motor (42) for keeping the tape (TP) still,
wherein
the drive motor (42) is configured to increase its output torque against a load received by the tape (TP) from the operator, and
the attaching recognition part (49, 100) is configured to detect a predetermined behavior of the drive motor (42) to increase the output torque to be equal to or larger than a predetermined threshold value against the load received by the tape (TP) from the operator, and recognize that the tape (TP) has been attached to the component feeding apparatus (4) corresponding to the drive motor (42) having the predetermined behavior detected.

2. A component mounting apparatus (10), comprising:
a reel holder (32) configured to detachably hold reels (5) having tapes (TP) accommodating components wound thereon;
a plurality of component feeding apparatuses (4) configured to feed the components accommodated in the attached tapes (TP), the tapes (TP) pulled out from the reels (5) held by the reel holder (32) being attachable to the component feeding apparatuses (4);
a head unit (60) configured to mount the components fed by the component feeding apparatuses (4) on a board (1); and
a behavior part (42) which is provided for each of the plurality of component feeding apparatuses (4) and configured to behave according to a load applied by an operator to the tape (TP) attached to the corresponding component feeding apparatus (4), wherein the behavior part (42) is a drive motor (42) configured to drive the tape (TP) attached to the component feeding apparatus (4);
**characterized by**
an attaching recognition part (49, 100) configured to give a constant torque command to the drive motor (42) for keeping an output torque constant,
wherein
the drive motor (42) is configured to rotate according to a load received by the tape (TP) from the operator, and
the attaching recognition part (49, 100) is configured to detect a predetermined behavior of the drive motor (42) to rotate by a predetermined threshold value or more against the load received by the tape (TP) from the operator, and recognize that the tape (TP) has been attached to the component feeding apparatus (4) corresponding to the drive motor (42) having the predetermined behavior detected.

3. A setup method of a component mounting apparatus (10) including a plurality of component feeding apparatuses (4) configured to feed components accommodated in attached tapes (TP), the tapes (TP) pulled out from reels (5) detachably held by a reel holder (32) being attachable to the component feeding apparatuses (4), a head unit (60) being configured to mount the components fed by the component feeding apparatuses (4) on a board (1), comprising:
behaving of a behavior part (42) according to a load applied by an operator to the tape (TP) attached to the corresponding component feeding apparatus (4), the behavior part (42) being provided for each of the plurality of component feeding apparatuses (4), wherein the behavior part (42) is a drive motor (42) configured to drive the tape (TP) attached to the component feeding apparatus (4);
**characterized by**
giving a still command to the drive motor (42) for keeping the tape (TP) still;
increasing an output torque of the drive motor (42) against a load received by the tape (TP) from the operator; and
detecting a predetermined behavior of the drive motor (42) to increase the output torque to be equal to or larger than a predetermined threshold value against the load received by the tape (TP) from the operator and recognizing that the tape (TP) has been attached to the component feeding apparatus (4) corresponding to the drive motor (42) having the predetermined behavior detected.

4. A setup method of a component mounting apparatus (10) including a plurality of component feeding apparatuses (4) configured to feed components accommodated in attached tapes (TP), the tapes (TP) pulled out from reels (5) detachably held by a reel holder (32) being attachable to the component feeding apparatuses (4), a head unit (60) being configured to mount the components fed by the component feeding apparatuses (4) on a board (1), comprising:
behaving of a behavior part (42) according to a load applied by an operator to the tape (TP) attached to the corresponding component feeding apparatus (4), the behavior part (42) being provided for each of the plurality of component feeding apparatuses (4), wherein the behavior part (42) is a drive motor (42) configured to drive the tape (TP) attached to the component feeding apparatus (4);
**characterized by**
giving a constant torque command to the drive motor (42) for keeping an output torque constant;
rotating the drive motor (42) according to a load received by the tape (TP) from the operator; and
detecting a predetermined behavior of the drive motor (42) to rotate by a predetermined threshold value or more against the load received by the tape (TP) from the operator and recognizing that the tape (TP) has been attached to the component feeding apparatus (4) corresponding to the drive motor (42) having the predetermined behavior detected.

## Patentansprüche

1. Komponentenmontageeinrichtung (10), umfassend:
einen Spulenhalter (32), der so ausgestaltet ist, dass er Spulen (5) abnehmbar hält, die darauf gewickelte Bänder (TP) aufweisen, die Komponenten unterbringen;
eine Vielzahl von Komponentenzufuhreinrichtungen (4), die so ausgestaltet sind, dass sie die in den befestigten Bändern (TP) untergebrachten Komponenten zuführen, wobei die Bänder (TP), die von den Spulen (5) herausgezogen werden, die von dem Spulenhalter (32) gehalten werden, an den Komponentenzufuhreinrichtungen (4) befestigbar sind;
eine Kopfeinheit (60), die so ausgestaltet ist, dass sie die von den Komponentenzufuhreinrichtungen (4) zugeführten Komponenten an einer Platte (1) montiert; und
einen Verhaltensteil (42), der für jede von der Vielzahl von Komponentenzufuhreinrichtungen (4) bereitgestellt ist und so ausgestaltet ist, dass er sich gemäß einer Last verhält, die von einem Bediener auf das Band (TP) angewandt wird, das an der entsprechenden Komponentenzufuhreinrichtung (4) befestigt ist, wobei der Verhaltensteil (42) ein Antriebsmotor (42) ist, der so ausgestaltet ist, dass er das an der Komponentenzufuhreinrichtung (4) befestigte Band (TP) antreibt;
**gekennzeichnet durch**
einen Befestigungserkennungsteil (49, 100), der so ausgestaltet ist, dass er einen Standbefehl so an den Antriebsmotor (42) ausgibt, dass das Band (TP) stehend gehalten wird,
wobei
der Antriebsmotor (42) so ausgestaltet ist, dass er sein Ausgangsdrehmoment gegen eine durch das Band (TP) von dem Bediener empfangene Last erhöht, und
der Befestigungserkennungsteil (49, 100) so ausgestaltet ist, dass er ein vorbestimmtes Verhalten des Antriebsmotors (42) feststellt, dass das Ausgangsdrehmoment gegen die durch das Band (TP) von dem Bediener empfangene Last so erhöht wird, dass es gleich oder größer als ein vorbestimmter Schwellenwert ist, und erkennt, dass das Band (TP) an der Komponentenzufuhreinrichtung (4) befestigt wurde, die dem Antriebsmotor (42) entspricht, bei dem das vorbestimmte Verhalten festgestellt wird.

2. Komponentenmontageeinrichtung (10), umfassend:
einen Spulenhalter (32), der so ausgestaltet ist, dass er Spulen (5) abnehmbar hält, die Bänder (TP) aufweisen, die darauf gewickelte Komponenten unterbringen;
eine Vielzahl von Komponentenzufuhreinrichtungen (4), die so ausgestaltet sind, dass sie die in den befestigten Bändern (TP) untergebrachten Komponenten zuführen, wobei die Bänder (TP), die von den Spulen (5) herausgezogen werden, die von dem Spulenhalter (32) gehalten werden, abnehmbar an den Komponentenzufuhreinrichtungen (4) befestigbar sind;
eine Kopfeinheit (60), die so ausgestaltet ist, dass sie die von den Komponentenzufuhreinrichtungen (4) zugeführten Komponenten an einer Platte (1) montiert; und
einen Verhaltensteil (42), der für jede von der Vielzahl von Komponentenzufuhreinrichtungen (4) bereitgestellt ist und so ausgestaltet ist, dass er sich gemäß einer Last verhält, die von einem Bediener auf das Band (TP) angewandt wird, das an der entsprechenden Komponentenzufuhreinrichtung (4) befestigt ist, wobei der Verhaltensteil (42) ein Antriebsmotor (42) ist, der so ausgestaltet ist, dass er das an der Komponentenzufuhreinrichtung (4) befestigte Band (TP) antreibt;
**gekennzeichnet durch**
einen Befestigungserkennungsteil (49, 100), der so ausgestaltet ist, dass er einen Konstantes-Drehmoment-Befehl an den Antriebsmotor (42) ausgibt, derart dass ein Ausgangsdrehmoment konstant gehalten wird,
wobei
der Antriebsmotor (42) so ausgestaltet ist, dass er sich gemäß einer Last dreht, die durch das Band (TP) von dem Bediener empfangen wird, und
der Befestigungserkennungsteil (49, 100) so ausgestaltet ist, dass er ein vorbestimmtes Verhalten des Antriebsmotors (42) feststellt, dass er sich mit einem vorbestimmten Schwellenwert oder höher gegen die durch das Band (TP) von dem Bediener empfangene Last dreht, und erkennt, dass das Band (TP) an der Komponentenzufuhreinrichtung (4) befestigt wurde, die dem Antriebsmotor (42) entspricht, bei dem das vorbestimmte Verhalten festgestellt wird.

3. Einrichtungsverfahren einer Komponentenmontageeinrichtung (10), die eine Vielzahl von Komponentenzufuhreinrichtungen (4) umfasst, die so ausgestaltet sind, dass sie Komponenten zuführen, die in befestigten Bändern (TP) untergebracht sind, wobei die Bänder (TP), die von Spulen (5) herausgezogen werden, die abnehmbar von einem Spulenhalter (32) gehalten werden, an den Komponentenzufuhreinrichtungen (4) befestigbar sind, wobei eine Kopfeinheit (60) so ausgestaltet ist, dass sie die von den Komponentenzufuhreinrichtungen (4) zugeführten Komponenten an einer Platte (1) montiert, umfassend:
Verhalten eines Verhaltensteils (42) gemäß einer Last, die von einem Bediener auf das Band (TP) angewandt wird, das an der entsprechenden Komponentenzufuhreinrichtung (4) befestigt ist, wobei der Verhaltensteil (42) für jede von der Vielzahl von Komponentenzufuhreinrichtungen (4) bereitgestellt wird, wobei der Verhaltensteil (42) ein Antriebsmotor (42) ist, der so ausgestaltet ist, dass er das Band (TP) antreibt, das an der Komponentenzufuhreinrichtung (4) befestigt ist;
**gekennzeichnet durch**
Ausgeben eines Standbefehls an den Antriebsmotor (42), derart dass das Band (TP) stehend gehalten wird;
Erhöhen eines Ausgangsdrehmoments des Antriebsmotors (42) gegen eine durch das Band (TP) von dem Bediener empfangene Last; und
Feststellen eines vorbestimmten Verhaltens des Antriebsmotors (42), dass das Ausgangsdrehmoment gegen die durch das Band (TP) von dem Bediener empfangene Last so erhöht wird, dass es gleich oder größer als ein vorbestimmter Schwellenwert ist, und Erkennen, dass das Band (TP) an der Komponentenzufuhreinrichtung (4) befestigt wurde, die dem Antriebsmotor (42) entspricht, bei dem das vorbestimmte Verhalten festgestellt wird.

4. Verfahren zur Einrichtung einer Komponentenmontageeinrichtung (10), die eine Vielzahl von Komponentenzuführeinrichtungen (4) umfasst, die so ausgestaltet sind, dass sie Komponenten zuführen, die in befestigten Bändern (TP) untergebracht sind, wobei die Bänder (TP), die von Spulen (5) herausgezogen werden, die von einem Spulenhalter (32) abnehmbar gehalten werden, an den Komponentenzufuhreinrichtungen (4) befestigbar sind, wobei eine Kopfeinheit (60) so ausgestaltet ist, dass sie die Komponenten, die von den Komponentenzufuhreinrichtungen (4) zugeführt werden, an einer Platte (1) montiert, umfassend:
Verhalten eines Verhaltensteils (42) gemäß einer von einem Bediener auf das Band (TP) angewandten Last, das an der entsprechenden Komponentenzufuhreinrichtung (4) befestigt ist, wobei der Verhaltensteil (42) für jede von der Vielzahl von Komponentenzufuhreinrichtungen (4) bereitgestellt wird, wobei der Verhaltensteil (42) ein Antriebsmotor (42) ist, der so ausgestaltet ist, dass er das Band (TP), das an der Komponentenzufuhreinrichtung (4) befestigt ist, antreibt;
**gekennzeichnet durch**
Ausgeben eines Konstantes-Drehmoment-Befehls an den Antriebsmotor (42), derart dass ein Ausgangsdrehmoment konstant gehalten wird;
Drehen des Antriebsmotors (42) gemäß einer durch das Band (TP) von dem Bediener empfangenen Last; und
Feststellen eines vorbestimmten Verhaltens des Antriebsmotors (42), dass er sich mit einem vorbestimmten Schwellenwert oder höher gegen eine durch das Band (TP) von dem Bediener empfangene Last dreht, und Erkennen, dass das Band (TP) an der Komponentenzufuhreinrichtung (4) befestigt wurde, die dem Antriebsmotor (42) entspricht, bei dem das vorbestimmte Verhalten festgestellt wird.

## Revendications

1. Appareil de montage de composant (10) comportant :
un support de bobine (32) conçu pour maintenir de façon détachable des bobines (5) ayant des bandes (TP) logeant des composants enroulés sur celles-ci ;
une pluralité d'appareils d'apport de composants (4) conçus pour apporter les composants logés dans les bandes (TP) attachées, les bandes (TP) extraites des bobines (5) maintenues par le support de bobine (32) pouvant être attachées aux appareils d'apport de composants (4) ;
une unité de tête (60) conçue pour monter les composants apportés par les appareils d'apport de composants (4) sur une planche (1) ; et
une partie comportement (42) qui est prévue pour chaque appareil parmi la pluralité d'appareils d'apport de composants (4) et conçue pour se comporter en fonction d'une charge appliquée par un opérateur à la bande (TP) attachée à l'appareil d'apport de composants (4) correspondant, dans lequel la partie comportement (42) est un moteur d'entraînement (42) conçu pour entraîner la bande (TP) attachée à l'appareil d'apport de composants (4) ;
**caractérisé par**
une partie reconnaissance d'attache (49, 100) conçue pour attribuer une instruction d'immobilité au moteur d'entraînement (42) afin de maintenir la bande (TP) immobile,
dans lequel
le moteur d'entraînement (42) est conçu pour augmenter son couple de sortie par rapport à une charge reçue par la bande (TP) de la part de l'opérateur et
la partie reconnaissance d'attache (49, 100) est conçue pour détecter un comportement prédéterminé du moteur d'entraînement (42) afin d'augmenter le couple de sortie pour qu'il soit égal ou supérieur à une valeur seuil prédéterminée par rapport à la charge reçue par la bande (TP) de la part de l'opérateur et reconnaître que la bande (TP) a été attachée à l'appareil d'apport de composants (4) correspondant au moteur d'entraînement (42) ayant le comportement prédéterminé détecté.

2. Appareil de montage de composant (10) comportant :
un support de bobine (32) conçu pour maintenir de façon détachable des bobines (5) ayant des bandes (TP) logeant des composants enroulés sur celles-ci ;
une pluralité d'appareils d'apport de composants (4) conçus pour apporter les composants logés dans les bandes (TP) attachées, les bandes (TP) extraites des bobines (5) maintenues par le support de bobine (32) pouvant être attachées aux appareils d'apport de composants (4) ;
une unité de tête (60) conçue pour monter les composants apportés par les appareils d'apport de composants (4) sur une planche (1) ; et
une partie comportement (42) qui est prévue pour chaque appareil parmi la pluralité d'appareils d'apport de composants (4) et conçue pour se comporter en fonction d'une charge appliquée par un opérateur à la bande (TP) attachée à l'appareil d'apport de composants (4) correspondant, dans lequel la partie comportement (42) est un moteur d'entraînement (42) conçu pour entraîner la bande (TP) attachée à l'appareil d'apport de composants (4) ;
**caractérisé par**
une partie de reconnaissance d'attache (49, 100) conçue pour attribuer une instruction de couple constant au moteur d'entraînement (42) afin de maintenir un couple constant de sortie,
dans lequel
le moteur d'entraînement (42) est conçu pour tourner en fonction d'une charge reçue par la bande (TP) de la part de l'opérateur et
la partie reconnaissance d'attache (49, 100) est conçue pour détecter un comportement prédéterminé du moteur d'entraînement (42) afin de tourner selon une valeur seuil prédéterminée ou plus par rapport à la charge reçue par la bande (TP) de la part de l'opérateur et reconnaître que la bande (TP) a été attachée à l'appareil d'apport de composants (4) correspondant au moteur d'entraînement (42) ayant le comportement prédéterminé détecté.

3. Procédé de paramétrage d'un appareil de montage de composant (10) incluant une pluralité d'appareils d'apport de composants (4) conçus pour apporter des composants logés dans des bandes (TP) attachées, les bandes (TP) extraites des bobines (5) maintenues de façon détachable par un support de bobine (32) pouvant être attachées aux appareils d'apport de composants (4), une unité de tête (60) étant conçue pour monter les composants apportés par les appareils d'apport de composants (4) sur une planche (1), comportant :
le comportement d'une partie comportement (42) en fonction d'une charge appliquée par un opérateur à la bande (TP) attachée à l'appareil d'apport de composants (4) correspondant, la partie comportement (42) étant prévue pour chaque appareil parmi la pluralité d'appareils d'apport de composants (4), dans lequel la partie comportement (42) est un moteur d'entraînement (42) conçu pour entraîner la bande (TP) attachée à l'appareil d'apport de composants (4) ;
**caractérisé par**
l'attribution d'une instruction d'immobilité au moteur d'entraînement (42) pour maintenir la bande (TP) immobile ;
l'augmentation d'un couple de sortie du moteur d'entraînement (42) par rapport à une charge reçue par la bande (TP) de la part de l'opérateur ; et
la détection d'un comportement prédéterminé du moteur d'entraînement (42) pour augmenter le couple de sortie afin qu'il soit égal ou supérieur à une valeur seuil prédéterminée par rapport à la charge reçue par la bande (TP) de la part de l'opérateur et la reconnaissance que la bande (TP) a été attachée à l'appareil d'apport de composants (4) correspondant au moteur d'entraînement (42) ayant le comportement prédéterminé détecté.

4. Procédé de paramétrage d'un appareil de montage de composant (10) incluant une pluralité d'appareils d'apport de composants (4) conçus pour apporter des composants logés dans des bandes (TP) attachées, les bandes (TP) extraites de bobines (5) maintenues de façon détachable par un support de bobine (32) pouvant être attachées aux appareils d'apport de composants (4), une unité de tête (60) étant conçue pour monter les composants apportés par les appareils d'apport de composants (4) sur une planche (1), comportant :
le comportement d'une partie comportement (42) en fonction d'une charge appliquée par un opérateur à la bande (TP) attachée à l'appareil d'apport de composants (4) correspondant, la partie comportement (42) étant prévue pour chaque appareil parmi la pluralité d'appareils d'apport de composants (4), dans lequel la partie comportement (42) est un moteur d'entraînement (42) conçu pour entraîner la bande (TP) attachée à l'appareil d'apport de composants (4) ;
**caractérisé par**
l'attribution d'une instruction de couple constant au moteur d'entraînement (42) pour maintenir un couple de sortie constant ;
la rotation du moteur d'entraînement (42) en fonction d'une charge reçue par la bande (TP) de la part de l'opérateur ; et
la détection d'un comportement prédéterminé du moteur d'entraînement (42) pour qu'il tourne selon une valeur seuil prédéterminée ou plus par rapport à la charge reçue par la bande (TP) de la part de l'opérateur et la reconnaissance que la bande (TP) a été attachée à l'appareil d'apport de composants (4) correspondant au moteur d'entraînement (42) ayant le comportement prédéterminé détecté.
